# EUROPEAN PATENT APPLICATION

(11) **EP 3 799 965 A1**
(43) Date of publication of application: **07.04.2021**
(21) Application number: 19830446.1
(22) Date of filing: 10.06.2019
(51) Int. Cl.: B05D 7/24, B05D 3/00, C04B 41/88, C04B 41/51, C09D 1/00

(54) **METALLIZED CERAMIC SUBSTRATE AND METHOD FOR MANUFACTURING SAME**

(30) Priority: 04.07.2018 KR 20180077822
(71) Applicant: Han, Mun Soo, Jeonju-si, Jeollabuk-do 54944 (KR)
(72) Inventor: JUNG, Young Sung, Yongin-si, Gyeonggi-do 16952 (KR); HAN, Mun Soo, Jeonju-si, Jeollabuk-do 54944 (KR)
(74) Representative: Arth, Hans-Lothar
(86) International application number: PCT/KR2019/006949
(87) International publication number: WO 2020/009338

(57) **Abstract**

The present invention relates to a metalized ceramic substrate and a method for manufacturing the same. The method for manufacturing a metalized ceramic substrate of the present invention comprises the steps of: mixing copper powder and metal oxide to manufacture a copper paste; applying the copper paste to an upper surface of a ceramic substrate; and sintering the copper paste to form a copper metallization layer on the upper surface of the ceramic substrate. According to the present invention, it is possible to form, on the ceramic substrate, a thin copper metallization layer with high density, high bonding strength and low impurities.

## Description

### [Field of Invention]

The present invention relates to a ceramic metalized substrate and a manufacturing method thereof, and more particularly, to a ceramic metalized substrate and a method for manufacturing the same, wherein a copper metalizing layer is formed of copper powder containing metal oxide.

### [Background of Invention]

Ceramic is a kind of inorganic compound made by heating and cooling non-metallic solids. In general, a ceramic material does not transfer electricity well while withstanding high temperature and, therefore, is used in various applications such as electronic materials and precision mechanical materials.

Among such ceramic materials, aluminum oxide (alumina, Al₂O₃), aluminum nitride (AlN), silicon nitride (Si₃N₄), etc. have not only high thermal conductivity but also excellent material stability at high temperature. Therefore, these materials are typically used to efficiently dissipate heat and improve durability of components generating a lot of heat such as light emitting diodes (LEDs) or power semiconductors.

In order to use ceramics as a substrate for electronic components, a ceramic substrate may be manufactured by bonding metal conductors such as copper to one or both surfaces thereof, and copper wirings may be formed in a given pattern thereon through screen printing or lithography. On the other hand, it is not easy to attach a copper layer, which is a metal, to a non-metallic ceramic substrate in order to obtain adhesive force. Accordingly, various processes for manufacturing a ceramic metalized substrate having a metalizing layer formed thereon have been developed. Direct Bonded Copper (DBC) is formed by a method of directly bonding a copper plate to Al₂O₃ through eutectic reaction between a copper (Cu) metal oxide and Al₂O₃. Nitride-based ceramic such as AlN may be applied after firstly performing a process of forming an oxide layer (Al₂O₃) on a surface of the ceramic at a high temperature.

In the DBC method, a copper plate must be oxidized at a high temperature to form a copper oxide layer on the surface thereof. Therefore, in order to bond the copper plate to a ceramic substrate, a high temperature furnace under are ductive atmosphere in which oxygen partial pressure is controlled is needed. Further, since the oxide layer must be uniformly formed on the copper plate, there is a limitation in proceeding the process if a thickness of a plate-shaped material is too thin. Therefore, the DBC method is not suitable for forming a copper layer of 100 µm or less, but is generally used when forming a copper layer of about 100 µm or more.

Korean Patent Laid-Open Publication No. 10-2014-0026632 (Method for manufacturing a metal oxide-based ceramic circuit board and the metal oxide-based ceramic circuit board) has disclosed a method of integrally bonding a copper plate to a metal oxide-based ceramic substrate wherein a copper plate is disposed on a metal oxide-based ceramic substrate to form a laminate, followed by heating the same.

A brazing method is a heat treatment process at a high temperature with a brazing alloy disposed between ceramic and copper. During heat treatment at a high temperature, small amounts of Ti, Zr, etc. contained in the brazing alloy may react with AlN to form an intermediate layer, which in turn increases a bonding strength of the interface.

In case of using a Ag-Cu-Ti brazing alloy, a paste containing expensive Ag and Ti should be used as a binder, bonding should be performed in a vacuum atmosphere, and additional removal of Ag/Ti is required for pattern formation. Therefore, there is a disadvantage that equipment costs and processing costs are increased. Although wettability of the molten brazing material and the ceramic substrate is improved due to Ti, a reaction product with Ti (TiO₂, TiN, etc.) is formed at the bonding interface, which is rigid and likely brittles, so that the ceramic substrate may entail a risk of cracking under cold-heat cycle load.

A direct plating copper (DPC) method uses a sputtering device to form a metalizing intermediate layer (seed, usually Ti) on a ceramic substrate, and then additionally forms a metal layer through electroless plating, printing, or the like, followed by forming a copper layer with desired thickness through electroplating. This method has problems including, for example, high raw material costs, expensive sputtering devices, reduction in productivity due to batch production, etc.

A paste method is a process of mixing Cu powder and an inorganic material, applying the mixture at a predetermined thickness in the form of powder or paste, and then sintering the same in a high temperature oxidation/reduction atmosphere in order to form a metalizing layer. This method uses an inorganic material which is admixed to form a Cu metalizing layer. However, the inorganic material is substantially foreign matter causing a problem of lowering a purity of Cu, thereby deteriorating electrical and thermal properties.

Korean Registered Patent Publication No. 10-1766426 (copper layer manufacturing method) has disclosed a process for formation of a Cu layer wherein, after preparing copper formate (Cu(COOH)₂) powder, a copper formate paste is prepared and printed on a ceramic substrate through screen printing, followed by heat treatment in a nitrogen atmosphere. However, in this case, there is a problem that the Cu layer does not achieve strong adhesion to the ceramic substrate.

### [Prior Art Document]

### [Patent Document]

1. Korean Patent Laid-Open Publication No. 10-2014-0026632
2. Korean Registered Patent Publication No. 10-1766426

### [Summary of Invention]

### [Technical Problem to be Solved]

It is an object of the present invention to provide a method for preparing a copper metalizing layer having a dense structure on a ceramic substrate.

It is another object of the present invention to provide a method for preparing a copper metalizing layer having a high bonding strength with a ceramic substrate.

It is a further object of the present invention to provide a method for preparing a copper metalizing layer having a high copper content on a ceramic substrate.

It is still a further object of the present invention to provide a copper ceramic conjugate formed by such a method as described above.

### [Technical Solution]

In order to achieve the above objects, the present invention provides a method for manufacturing a ceramic metalized substrate, which includes: mixing copper powder and metal oxide to prepare a copper paste; applying the copper paste to an upper surface of a ceramic substrate; and sintering the copper paste to form a copper metalizing layer on the upper surface of the ceramic substrate.

Preferably, the metal oxide may include at least one selected from a group consisting of copper(II) oxide (CuO), copper(I) oxide (Cu₂O), iron(II) oxide (FeO), iron(III) oxide (Fe₂O₃), iron(II, III) oxide (Fe₃O₄). Alternatively, the metal oxide may have a copper oxide layer on a surface of the copper powder.

Preferably, a diameter of the copper powder may range from 0.1 to 10.0 µm, and a diameter of the metal oxide may be 5.0 µm or less.

Preferably, the ceramic substrate is a metal oxide-based ceramic substrate made of Al₂O₃ or ZrO₂. Alternatively, the ceramic substrate may be a non-metallic oxide-based ceramic substrate made of AlN or Si₃N₄, the surface of which was subjected to oxidation.

Preferably, the paste application process may use at least one selected from a group consisting of screen printing, spraying and 3D printing. Further, the sintering process is carried out at a temperature of 1065 to 1083°C in a vacuum or reductive atmosphere. This process may further include thickening the copper metalizing layer by at least one method selected from a group consisting of electroless plating, electroplating, sputtering and printing.

In another aspect, the ceramic metalized substrate according to the present invention may include a ceramic substrate having thermal conductivity of 20 W/mK or more and a copper metalizing layer formed on an upper surface of the ceramic substrate, wherein the copper metalizing layer has a grain structure in which grains have an average diameter of 5 to 50 µm, and the copper metalizing layer has a thickness of 1 to 100 µm.

Preferably, a bonding strength between the copper metalizing layer and the ceramic substrate may be at least 4 N/mm or more. Further, the copper metalizing layer may also have a copper content of at least 95%.

### [Effect of Invention]

According to the present invention as described above, since eutectic bonding by copper powder and metal oxide is used, a copper metalizing layer having a thin thickness, a large grain size and a dense structure may be prepared on the ceramic substrate. Further, according to the present invention, since the copper metalizing layer has a dense structure, the copper metalizing layer having a high bonding strength may be formed on the ceramic substrate. In addition, according to the present invention, no flux is used in the paste, the copper metalizing layer having a high copper content may be prepared on the ceramic substrate, thereby achieving high conductivity of the copper layer.

### [Brief Description of Drawings]

FIG. 1 is a flowchart illustrating a method for manufacturing a ceramic metalized substrate according to an embodiment of the present invention.
FIG. 2 is a cross-sectional view illustrating a state in which a copper paste is applied to a ceramic substrate in a process of manufacturing the ceramic metalized substrate according to an embodiment of the present invention.
FIG. 3 is a cross-sectional view illustrating use of the ceramic metalized substrate according to an embodiment of the present invention, which was attached to a heat sink.
FIGS. 4A and 4B are photographs showing comparison of grain sizes of the ceramic metalized substrate according to an embodiment of the present invention with the prior art.
FIGS. 5A and 5B are schematic diagrams illustrating a testing method of adhesion of a copper metalizing layer to the ceramic metalized substrate according to an embodiment of the present invention.

### [Detailed Description of Preferred Embodiments of Invention]

The above objects, features, and advantages will become more apparent from the following detailed description with reference to the accompanying drawings, and thus, those skilled in the art to which the present invention pertains may easily implement the technical idea of the present invention. In addition, in describing the present invention, if concrete description of known technology related to the present invention is determined to unnecessarily obscure the gist of the present invention, the detailed description thereof will be omitted.

Hereinafter, exemplary embodiments of the present invention will be described in detail with reference to the accompanying drawings.

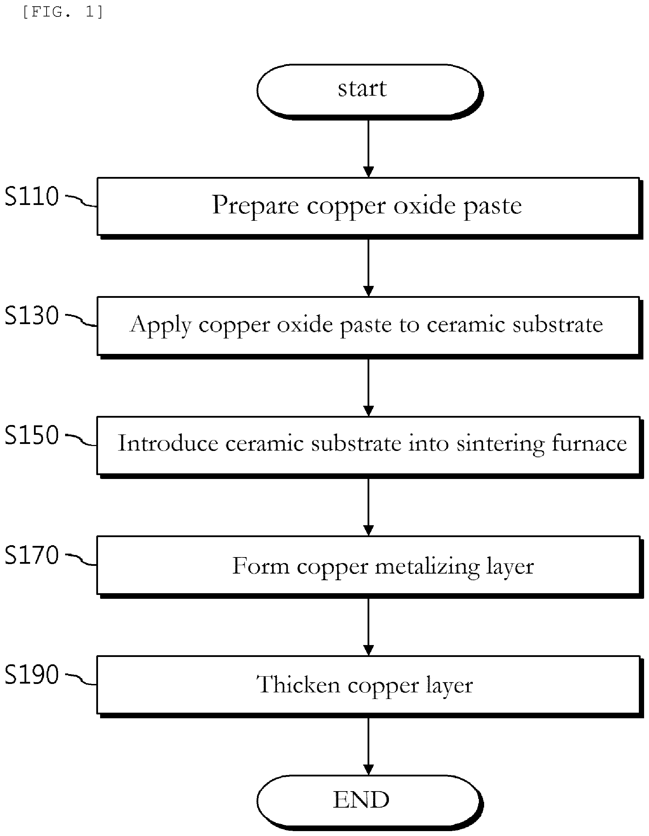

FIG. 1 is a flowchart illustrating a method for manufacturing a ceramic metalized substrate according to an embodiment of the present invention.

First, a copper paste is prepared by blending a mixture of copper powder and metal oxide in a proper solvent (S110). The copper paste does not include separate inorganic materials such as flux, impurities may be minimized and, even after sintering, the copper content is still sufficiently high to afford favorable conductivity.

A diameter of the powder may be represented by a median diameter D₅₀. The median diameter D₅₀ corresponds to a size of particles in the center (50%) when the particles are aligned in order. Unless stated otherwise in the specification, the diameter refers to a D₅₀ value.

The diameter (D₅₀) of the copper powder is preferably 10.0 µm or less. If the particle diameter is larger than 10 µm, non-uniformity is increased and the metal oxide may not be evenly mixed. In order to increase particle homogeneity and improve uniformity of the copper metalizing layer, the diameter of each of the copper powder and the copper oxide powder is preferably 0.1 µm or more. The diameter of the metal oxide may be 5.0 µm or less, which is smaller than the maximum diameter of the copper powder, so that the metal oxide can be evenly mixed with the copper powder. As the metal oxide, copper(II) oxide (CuO), copper(I) oxide (Cu₂O), iron(II) oxide (FeO), iron(III) oxide (Fe₂O₃), iron(II, III) oxide (Fe₃O₄) and the like may be used.

Further, metal oxide prepared by oxidizing the surface of the copper powder may be used. The prepared metal oxide may be formed in a shape in which the outer surface of the copper powder is coated with a copper oxide layer.

Next, the prepared copper paste is applied to a ceramic substrate(S130).As the ceramic substrate, not only a metal oxide-based ceramic substrate but also a non-metallic oxide-based ceramic substrate may be used. Examples of the metal oxide-based ceramic substrate may include aluminum oxide (Al₂O₃), zirconium oxide (ZrO₂), and the like. Examples of the non-metallic oxide-based ceramic substrate may include aluminum nitride (AlN) and silicon nitride (Si₃N₄). However, in case of the non-metallic oxide-based ceramic substrate, in order to easily facilitate adhesion of the ceramic substrate to copper during eutectic reaction, the substrate is preferably used after oxidizing the surface thereof.

The paste application method may include, for example, screen printing, spraying, 3D printing, etc. After forming the copper metalizing layer without electronic circuit patterning, the pattern may be formed later through exposure and etching processes. When the electronic circuit pattern is predetermined in advance, the electronic circuit pattern may be formed when applying the copper paste.

When applying the copper paste, a thickness of the copper layer may be adjusted by changing a squeeze angle, a migration speed, etc. An applied thickness is preferably set such that a thickness of the copper layer formed when the paste is completely sintered may reach 1 to 100 µm. If too thin, thickness non-uniformity is increased. On the other hand, if too thick, productivity is decreased.

Next, the ceramic substrate coated with the copper paste is put into the sintering furnace (S150).The sintering furnace is maintained at 1065 to 1083°C in a vacuum or reductive atmosphere to sinter the copper powder. The copper powder and oxygen may cause eutectic reaction at the above temperature and bond to the ceramic substrate.

In the absence of oxygen, when copper becomes "liquid" at a high temperature, copper is not wet with the ceramic, just like water and oil. Therefore, no strong bonding is achieved. On the other hand, in the presence of oxygen, eutectic reaction may occur and copper may be strongly bound to the ceramic substrate. In other words, even without a separate intermediate layer such as a brazing alloy, a certain amount of oxygen is required to obtain a strong bond between copper and ceramic.

An oxygen content preferably ranges from 0.1 to 1.0 wt. % in a total weight of the copper powder and the metal oxide. If the oxygen content is too small, sufficient adhesion may not be obtained. When the oxygen content is too high, a problem such as melting of edges may occur.

When the ceramic substrate is removed from the sintering furnace and cooled, a copper metalizing layer having a dense structure may be formed on the ceramic substrate (S170).The copper metalizing layer may have a dense structure and high adhesive strength with the ceramic substrate. In addition, since a flux or the like is not included, the copper content may be high to thus exhibit favorable electrical conductivity.

If necessary, a process of thickening the copper metalizing layer may be further included (S190).The thickening process is to form a copper layer on the copper metalizing layer through electroplating, electroless plating, sputtering, printing, or the like. The thickening process may further increase densification and conductivity, and may improve adhesion to electronic components attached on the copper layer.

Depending on the purpose of use of the copper metalizing layer, a copper sheet may be again bonded thereon by means of a DBC (direct bonded copper) method, or a component including copper as a major ingredient may be bonded. In case of using a copper plate, it is easier to obtain a thicker metal layer, as compared to when the copper paste is continuously processed to prepare such a thicker metal layer. According to characteristics of the metal plate having a dense structure, effects of improving electrical and thermal properties may be expected. Further, copper plated with dissimilar metals (for example, Ni, Au, Ag) other than copper, or dissimilar metals (for example, iron such as Kovar/nickel/chromium alloy) *per se* may be hybrid-bonded to the copper metalizing layer.

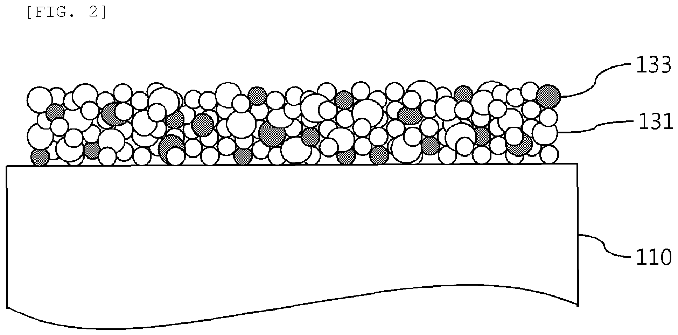

FIG. 2 is a cross-sectional view illustrating a state in which a copper paste is applied to a ceramic substrate in a process of manufacturing the ceramic metalized substrate according to an embodiment of the present invention. In this figure, a mixture of the copper powder 131 and the metal oxide 133 applied to the ceramic substrate 110 is shown. A diameter of the copper powder 131 is preferably 10.0 µm or less. If a diameter of particles is larger than 10 µm, non-uniformity becomes large and such a problem that metal oxides are not evenly mixed may occur. In order to increase particle homogeneity and thus improve uniformity of the copper metalizing layer, the diameter of the copper powder may be selected from a range of 0.1 µm or more.

The diameter of the metal oxide is 5.0 µm or less, which is smaller than the maximum diameter of the copper powder, and the metal oxide is evenly mixed with the copper powder. In order to increase the particle homogeneity, the diameter of the metal oxide powder may be selected from a range of 0.1 µm or more.

When entering a hot sintering furnace, the copper powder and the metal oxide begin to melt. Oxygen of the metal oxide may move outward rather than inward, and improve wettability of the copper melt at the interface between the ceramic substrate and the copper melt. Thus, upon cooling, a copper metalizing layer strongly bonded to the ceramic substrate may be obtained.

Meanwhile, the copper metalizing layer may form a reactant of the ceramic substrate and copper oxide near a boundary with the ceramic substrate. That is, a structure of the ceramic substrate-reactant-copper metalizing layer is formed so that the copper metalizing layer may be strongly adhered to the ceramic substrate. For example, when using an alumina (Al₂O₃) substrate, an Al₂O₃-CuO reactant is formed at the interface and a copper (Cu) metalizing layer is formed thereon. In this case, the generated reactant may include CuAl₂O₄, CuAlO₂, and the like.

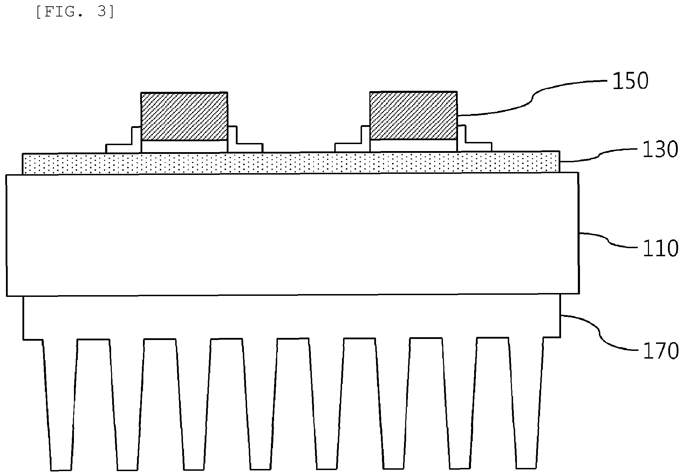

FIG. 3 is a cross-sectional view illustrating use of the ceramic metalized substrate according to an embodiment of the present invention, which was attached to a heat sink. The copper metalizing layer 130 is bonded to one surface of the ceramic substrate 110 and the electronic component 150 is mounted thereon. The heat sink 170 is attached to the other surface of the ceramic substrate 110.

Electronic components generating a lot of heat, such as LEDs and power semiconductors, must be connected to a heat sink in order to dissipate heat efficiently. Therefore, it is preferable to use a ceramic substrate having thermal conductivity of 20 W/mK or more as the substrate attached to the heat sink. With respect to some ceramic substrates and their specific thermal conductivity values for the above use, aluminum oxide (Al₂O₃) has thermal conductivity of 24 to 28 W/mk, aluminum nitride (AlN) has thermal conductivity of 150 to 250 W/mK, and silicon nitride (Si₃N₄) has quite high thermal conductivity of 70 to 80 W/mK.

The copper metalizing layer preferably has sufficient adhesive strength with the ceramic substrate. Due to characteristics of components acting under unfavorable conditions, a bonding strength is desirably 4 N/mm or more. To this end, a copper metalizing layer may be prepared using a copper paste containing copper powder and metal oxide on a ceramic substrate.

A thickness of the copper metalizing layer bonded to the ceramic substrate preferably ranges from 1 to 100 µm. If the thickness is greater than 100 µm, an amount of a copper layer to be removed is too large when a pattern is formed by an etching process and may cause a problem in forming a fine pattern. On the other hand, when the thickness is 1 µm or less, there is difficulty in obtaining an even thickness of the copper layer.

### [EXAMPLES]Preparation of Copper Paste

A copper paste is prepared by blending copper powder and copper oxide powder in a solvent. The copper powder used herein was Cu powder having a median diameter (D₅₀) of 2.0 to 2.5 µm, while Cu₂O powder having a median diameter (D₅₀) of 0.5 to 1.0 µm was used as the copper oxide powder. The solvent used herein was Texanol (C₁₂H₂₄O₃).

As shown in Table 1, the copper powder and the copper oxide powder were admixed in different composition ratios to prepare copper pastes. A proportional ratio of the copper powder among total powder was 99.5% by weight ("wt.%") under condition 1, and 91.0 wt.% under condition 8. In this case, a copper (Cu) content among total powder was 99.94 wt.% under condition 1, and 98.99 wt.% under condition 8. The copper (Cu) content is higher than the copper powder ratio because the copper oxide powder also contains copper.

**[TABLE 1]**

| | Copper powder (wt.%) | Copper oxide powder (wt.%) | Copper (Cu) content (wt.%) | Oxygen (O) content (wt.%) |
|---|---|---|---|---|
| Condition 1 | 99.5 | 0.5 | 99.94 | 0.06 |
| Condition 2 | 99.0 | 1.0 | 99.89 | 0.11 |
| Condition 3 | 98.5 | 1.5 | 99.83 | 0.17 |
| Condition 4 | 98.0 | 2.0 | 99.78 | 0.22 |
| Condition 5 | 97.0 | 3.0 | 99.66 | 0.34 |
| Condition 6 | 95.0 | 5.0 | 99.44 | 0.56 |
| Condition 7 | 93.0 | 7.0 | 99.22 | 0.78 |
| Condition 8 | 91.0 | 9.0 | 98.99 | 1. 01 |

If a viscosity of the copper paste is too large or low, screen printing becomes difficult. Therefore, the solvent was added in order to obtain a viscosity of the copper paste in the range of 10,000 to 50,000 cP. The viscosity of the copper paste or the amount of the solvent can be adjusted according to the screen printing conditions.

### [EXAMPLES]Preparation of Copper Metalizing Layer

An alumina (Al₂O₃) substrate was used as a ceramic substrate to form a copper metalizing layer. The ceramic substrate used herein has an area 140 × 190 mm² and a thickness of 0.635 mm.

As a method of applying the copper paste to the ceramic substrate, the screen printing method was used. Screen printing conditions may be adjusted along a printing thickness of the copper paste. The screen printing conditions were set in order to obtain a printing thickness of the copper paste in the range of 35 to 40 µm. A 200 to 300 mesh screen was prepared and printing was implemented while moving at a speed of 100 to 150 mm/sec at a squeeze angle of 60 to 80°.

After screen printing was completed, the copper paste-coated ceramic substrate was sintered for 10 minutes at a maximum temperature of 1075°C in a sintering furnace in a nitrogen atmosphere.

### [COMPARATIVE EXAMPLE] Copper Metalizing Layer Produced by Conventional Method

A copper paste was prepared by mixing a flux with the same copper powder as used in the examples. When the copper powder is heated to prepare a copper metalizing layer, an oxide layer is formed on the surface of the copper powderto prevent smooth adhesion with the substrate. Therefore, in order to inhibit formation of the oxide layer, the flux may be used. Flux materials may include, for example: borate salts such as potassium tetraborate (K₂B₄O₇), sodium tetraborate (Na₂B₄O₇), etc.; fluorides or chlorides such as potassium fluoride (KF), potassium chloride (KCl), zinc chloride (ZnCl₂), etc.; and oxides such as silica (SiO₂) and zinc oxide (ZnO).In Comparative Examples, a copper paste was prepared by adding 10% silica (SiO₂) flux to the copper powder.

The copper paste prepared by mixing the flux was subjected to screen printing on the ceramic substrate having the same specifications as those used in the examples. The screen printing conditions in the examples were applied to obtain the same thickness of the applied copper paste as in the examples. After completing screen printing, the ceramic substrate coated with the copper paste containing the flux was sintered at a maximum temperature of 900°C for 10 minutes in a sintering furnace in an oxygen atmosphere of 100 ppm.

### [EXAMPLE]Assessment of Characteristics

Surface conditions of the copper metalizing layers according to the examples and the comparative examples were observed under a microscope and grain sizes were compared.

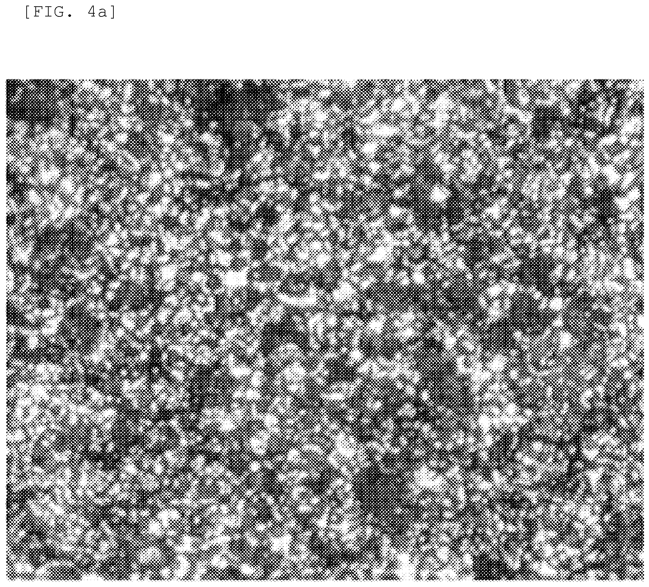

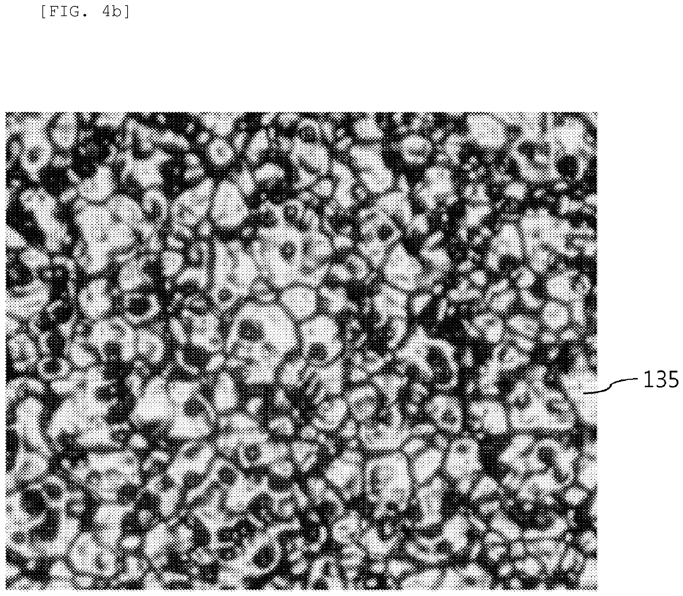

FIGS. 4A and 4B are photographs showing comparison of grain sizes of the ceramic metalized substrate according to an embodiment of the present invention with the prior art.FIG. 4A is a photograph showing the surface of the substrate manufactured by mixing a flux with copper powder and then sintering the mixture at 900°C in an atmosphere of 10 ppm oxygen according to a comparative example, and FIG. 4B is a photograph showing the surface of the substrate manufactured by mixing copper powder and copper metal oxide and then sintering the mixture at 1075°C in a reductive atmosphere according to condition n4 among the examples. In both cases, the copper powder was copper powder having a diameter of 2 to 2.5 µm, and a magnification of the photograph was 1,000 times.

FIG. 4A showed very little growth of copper particles, while FIG. 4B showed that grains 135 and grain boundary were formed due to great growth of particles. That is, according to the present example, it could be seen that copper particles can be grown to achieve strong adhesion with a ceramic substrate, compared to the prior art.

Table 2 is a table to indicate changes in respective sintering stages. In Table 2, a relative density is a ratio to a theoretical density of the sintered body, and a shrinkage ratio indicates a degree of shrinkage after sintering relative to a size before sintering. At the beginning of sintering, neck growth occurs and a network structure is formed in the copper particles. Beyond the middle stage of sintering, grain growth occurs wherein copper particles grow densely.

**[TABLE 2]**

| | Relative density | Shrinkage (%) | Remarks |
|---|---|---|---|
| Initial sintering stage | 0.5 to 0.6 | 4 to 5 | Neck growth |
| Middle sintering stage | 0.6 to 0.95 | 5 to 20 | Grain growth |
| Last sintering stage | 0.95 or more | 10 to 20 or more | Grain growth |

Since the grain growth is not seen in FIG. 4A, the comparative example does not ensure sufficient adhesive strength, whereas, in the case of FIG. 4B according to the present example, sufficient adhesive strength could be ensured between the ceramic substrate and the copper metalizing layer by grain growth. These results were confirmed in conditions 2 to 8 of Table 1.

An average diameter of the grains of the copper metalizing layer according to the present example was confirmed to range from 5 to 50 µm. The average diameter of the grains was determined by measuring diameters of the grains observed on the 1,000x micrograph and averaging the measured values.

If the average diameter of the grains is less than 5 µm, grain growth is not sufficiently conducted and adhesive strength cannot be ensured. If the average diameter of the grains is larger than 50 µm, the sintering temperature or time may be excessive, hence causing problems in equipment operation and productivity, as well as damage to the substrate.

### [EXAMPLE] Adhesion Test

Since the copper metalizing layer prepared according to the present example has high bonding strength, it is difficult to accurately measure exact adhesion by the conventional measurement method. Therefore, the adhesion test was performed by bonding a copper foil to the copper metalizing layer that was etched to be possibly peeled.

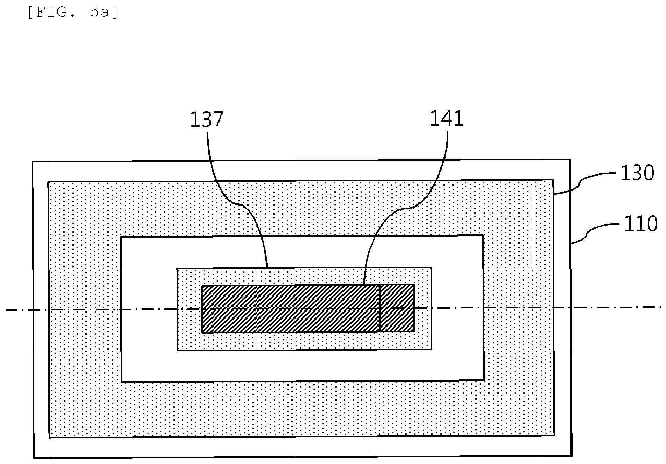

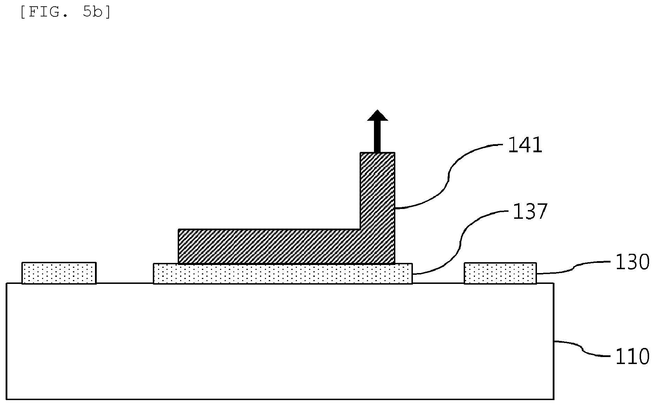

FIGS. 5A and 5B are schematic diagrams illustrating a testing method of adhesion of a copper metalizing layer to the ceramic metalized substrate according to an embodiment of the present invention. FIG. 5A is a plan view illustrating an etched state of the copper metalizing layer in the ceramic metalized substrate, which is viewed from the top of the ceramic metalized substrate. FIG. 5B is a cross-sectional view of the etched pattern portion in the ceramic metalized substrate, which is taken along the side and viewed from the side.

Looking at the test method in detail with reference to the drawings, firstly, the ceramic substrate 110 having an area of 40 x 30 mm² bonded to the copper metalizing layer 130 was etched to form a 25 x 5 mm² pattern 137 on the copper metalizing layer. Then, above the etched pattern, a copper foil 141 having a size (80 x 5 x 0.137) longer than the pattern was bonded through soldering (250 to 270°C). Further, the copper foil 141 protruding out of the etched pattern 137 was vertically folded, and an applied force when the etched pattern is peeled off was measured while pulling the copper foil in the direction of an arrow.

Table 3 shows experimental results of various examples listed in Table 1. In Table 3, a bonding strength according to a ratio of metal oxide (Cu₂O) powder, that is, oxygen (O) content is listed. All contents are expressed in weight percent. In the sintering process, the maximum temperature was maintained at 1075°C for 7 to 10 minutes while maintaining the reductive atmosphere.

**[TABLE 3]**

| | Copper oxide powder (wt.%) | Oxygen content (O) (wt.%) | Appearance | Bonding strength (N/mm) |
|---|---|---|---|---|
| Condition 1 | 0.5 | 0.06 | Partiallypo or bonding | 1.15 |
| Condition 2 | 1.0 | 0.11 | Good | 4.08 |
| Condition 3 | 1.5 | 0.17 | Good | 4.73 |
| Condition 4 | 2.0 | 0.22 | Good | 5.49 |
| Condition 5 | 3.0 | 0.34 | Good | 10.59 |
| Condition 6 | 5.0 | 0.56 | Good | 11.77 |
| Condition 7 | 7.0 | 0.78 | Good | 11.08 |
| Condition 8 | 9.0 | 1. 01 | Edge molten | 13.67 |

In Table 3, in the case of condition 1 with oxygen content of 0.06%, edge portions were bonded well whereas the central portion showed poor bonding with a bonding strength of 1.15 N/m as measured. Further, in the case of condition 8 with oxygen content of 1.01%, there is a problem that edges were molten after sintering although the bonding strength was favorable.

Therefore, in order to obtain a copper metalizing layer having sufficient bonding strength not less than 4 N/mm and good appearance, a mixture of the copper powder and the metal oxide desirably has oxygen content of 0.1 wt.% to 1.0 wt.% relative to a total weight of the mixture. Under such conditions, since the oxygen content is substantially less than 1%, the copper metalizing layer may contain 99% or more of copper. In the actual manufacturing process, other elements may also be included in the copper metalizing layer through various routes such as a substrate, sintering environments, etc. according to embodiments of the present invention, a copper metalizing layer including 95% or more of copper may be prepared.

As described above, embodiments of the present invention have been described in detail. It should be apparent to those skilled in the art that such specific techniques are merely preferred embodiments, and therefore, the scope of the present invention is not particularly limited thereto. Accordingly, it would be understood that the substantial scope of the present invention is defined by the appended claims and their equivalents.

### [Description of reference numerals]

- 110:: Ceramic substrate
- 130:: Copper metalizing layer
- 150:: Electronic components
- 170:: Heat sink

## Claims

1. A method for manufacturing a ceramic metalized substrate, comprising:
mixing copper powder and metal oxide to prepare a copper paste;
applying the copper paste to an upper surface of a ceramic substrate; and
sintering the copper paste to form a copper metalizing layer on the upper surface of the ceramic substrate.

2. The method according to claim 1, wherein the metal oxide includes at least one selected from a group consisting of copper(II) oxide (CuO), copper(I) oxide (Cu₂O), iron(II) oxide (FeO), iron(III) oxide (Fe₂O₃), iron(II, III) oxide (Fe₃O₄).

3. The method according to claim 1, wherein the metal oxide has a copper oxide layer on a surface of the copper powder.

4. The method according to claim 1, wherein a diameter of the copper powder ranges from 0.1 to 10.0µm, and a diameter of the metal oxide is 5.0 µm or less.

5. The method according to claim 1, wherein the ceramic substrate is a metal oxide-based ceramic substrate made of Al₂O₃ or ZrO₂.

6. The method according to claim 1, wherein the ceramic substrate is a non-metallic oxide-based ceramic substrate made of AlN or Si₃N₄, the surface of which was subjected to oxidation.

7. The method according to claim 1, wherein a process of applying the paste uses at least one selected from a group consisting of screen printing, spraying and 3D printing.

8. The method according to claim 1, wherein the sintering process is carried out at a temperature of 1065 to 1083°C in a vacuum or reductive atmosphere.

9. The method according to claim 1, further comprising a process of thickening the copper metalizing layer by at least one method selected from a group consisting of electroless plating, electroplating, sputtering and printing.

10. The method according to claim 1, further comprising a process of bonding a separate copper sheet on top of the copper metalizing layer by a DBC (direct bonded copper) method, or bonding a component including copper as a major ingredient thereon.

11. The method according to claim 1, further comprising hybrid-bonding copper plated with dissimilar metals other than copper, or dissimilar metals *per se* to the copper metalizing layer.

12. A ceramic metalized substrate, comprising:
a ceramic substrate having thermal conductivity of 20 W/mK or more; and
a copper metalizing layer formed on an upper surface of the ceramic substrate,
wherein the copper metalizing layer has a grain structure in which grains have an average diameter of 5 to 50µm, and a thickness of the copper metalizing layer ranges from 1 to 100µm.

13. The substrate according to claim 12, wherein a bonding strength between the copper metalizing layer and the ceramic substrate is 4 N/mm or more.

14. The substrate according to claim 12, wherein the copper metalizing layer has a copper content of 95% or more.

15. The substrate according to claim 12, wherein the ceramic substrate is a metal oxide-based ceramic substrate made of Al₂O₃ or ZrO₂.

16. The substrate according to claim 12, wherein the ceramic substrate is a non-metallic oxide-based ceramic substrate made of AlN or Si₃N₄.
